# EUROPEAN PATENT APPLICATION

(11) **EP 4 593 424 A1**
(43) Date of publication of application: **30.07.2025**
(21) Application number: 24154165.5
(22) Date of filing: 26.01.2024
(51) Int. Cl.: H04R 25/00

(54) **RECEIVER FOR A HEARING INSTRUMENT AND METHOD OF PRODUCING IT**

(71) Applicant: Sonova AG, 8712 Stäfa (CH)
(72) Inventor: WEIBEL, Manuel, 8703 Erlenbach (CH); SCHMIDT, Fabio, 8707 Uetikon am See (CH); MEYER, Jonas, 8712 Stäfa (CH); KUIPERS, Erwin, 8712 Staefa (CH)
(74) Representative: Liedtke & Partner Patentanwälte

(57) **Abstract**

The invention relates to a receiver (1) for a hearing instrument, the receiver (1) comprising:
- a case (6) having a tubular shape with at least one open end,
- a flexible or partially flexible printed circuit board (2) populated with a plurality of MEMS receiver cells (3), wherein the printed circuit board (2) is folded to form a hollow body and inserted in the case (6) with the MEMS receiver cells (3) facing inward and/or outward,
- at least one cap (7.1, 7.2) closing the open end of the case (6), wherein one of the caps (7.1) comprises a sound port (8) for guiding sound produced by the MEMS receiver cells (3) out of the receiver (1).

## Description

### Technical Field

The invention relates to a receiver for a hearing instrument and to a method of producing the receiver.

### Background of the Invention

With the latest developments in piezo MEMS (Micro Electro Mechanical Systems) based receivers, the technology comes close to the performance of balanced armature (BA) receivers and dynamic (moving coil) receivers. MEMS-receivers have many advantages, like mechanical resonances out of the hearable range, very robust design, and no requirement for the use of rare earth-elements.

Since MEMS receivers have been developed as speakers for mobile devices, like smartphones, they are optimized as a flat, free-field speaker. The acoustic output of a single MEMS-speaker is too low to use it in a hearing instrument. One could combine multiple MEMS-speakers to resolve this, but these would not fit into a human ear canal.

Known designs of different piezo-MEMS speakers are one cell structures or multiple cell structures on a flat PCB. This allows applying them as a speaker in a mobile device, in particular in TWS (true wireless stereo) earbuds. However, they do not fit into a human ear canal.

### Summary of the Invention

It is an object of the present invention to provide a novel receiver for a hearing instrument and a novel method of producing a receiver for a hearing instrument.

The object is achieved by a receiver for a hearing instrument according to claim 1 and by a method of producing a receiver for a hearing instrument according to claim 15.

Preferred embodiments of the invention are given in the dependent claims.

According to an aspect of the present invention, a receiver for a hearing instrument is proposed, the receiver comprising:
- a case having a tubular shape with at least one open end,
- a flexible or partially flexible printed circuit board populated with a plurality of MEMS receiver cells, wherein the printed circuit board is folded to form a hollow body and inserted in the case with the MEMS receiver cells facing inward and/or outward,
- at least one cap closing the open end of the case, wherein one of the caps comprises a sound port for guiding sound produced by the MEMS receiver cells out of the receiver.

In the context of the present invention, a MEMS receiver cell denotes a Micro Electro Mechanical System (MEMS) comprising one or at least one electroacoustic transducer configured to convert electric signals to acoustic signals or vice versa.

In an exemplary embodiment, the partially flexible printed circuit board comprises at least two generally rigid zones with a respective flexible fold serving as a hinge between pairs of adj acent rigid zones in each case, wherein at least some of the rigid zones are populated with the plurality of MEMS receiver cells, wherein the rigid zones comprise a more rigid material than the flexible folds or are made of the same material but are more rigid than the flexible folds due to the MEMS receiver cells arranged thereon.

In an exemplary embodiment, the hollow body formed from the printed circuit board has an at least basically tubular shape.

In an exemplary embodiment, the case and/or the hollow body formed from the printed circuit board have/has a polygonal, e.g. triangular, quadrangular, in particular rectangular or square, pentagonal, or hexagonal cross section, or a circular or oval cross section.

In an exemplary embodiment, the printed circuit board comprises two, three, four, five, six or more at least essentially rectangular rigid zones populated with one or more MEMS receiver cells each and arranged in parallel to each other with a respective fold separating each pair of adjacent rigid zones.

In an exemplary embodiment, one of the ends of the hollow body formed from the printed circuit board is closed by another rigid zone of the printed circuit board.

In an exemplary embodiment, two rigid zones at opposite ends of the printed circuit board comprise mutually complementary engagement structures configured to engage each other when the printed circuit board is folded to form the hollow body.

In an exemplary embodiment, at least one end of some or all parallel rigid zones have a lug configured to engage in a slot in the cap.

In an exemplary embodiment, the printed circuit board has two parallel rigid zones separated by a fold, wherein one of the rigid zones is folded onto the other rigid zone to form a hollow body resembling a booklet.

In an exemplary embodiment, the printed circuit board has four parallel rigid zones including two outer ones and two inner ones, wherein adjacent rigid zones are separated by a respective fold, wherein each outer rigid zone is folded onto the respectively adjacent inner rigid zone to form a pair, wherein the pairs are folded about a middle one of the folds one upon the other.

In an exemplary embodiment, the printed circuit board is folded to form a hollow body having a concave shape. E.g., the concave shape may resemble a water lily, a bowl or a concave mirror. In some examples, one or more MEMS receiver cells are arranged at a concavely curved surface of the printed circuit board, e.g., an inner surface. In some examples, one or more MEMS receiver cells are arranged at an outer surface of the printed circuit board, e.g., a surface opposing the concavely curved surface.

In this embodiment, the printed circuit board may have seven rigid zones populated with a MEMS receiver cell each. Three of the rigid zones are arranged in a row and separated by folds. The middle one of these rigid zones further has an adjacent fold at an edge 90° offset from the former rigid zones, and an adjacent fold at an edge opposite of the latter fold. The two further opposite folds are each followed by another rigid zone basically shaped as a wedge or an isosceles triangle with two equal length edges and a base attached to the respective fold. These two rigid zones may not be populated by MEMS receiver cells. The two equal length edges of the triangle or wedge have adjacent folds followed by a respective rigid zone which is again populated by a respective MEMS receiver cell. The populated rigid zones may be at least essentially square.

In an exemplary embodiment, at least one control chip configured to control the MEMS receiver cells, an ASIC and/or non-volatile memory chip is arranged on at least one of the rigid zones, e.g. instead of a MEMS receiver cell.

In an exemplary embodiment, a cap having a cable for electrically connecting the printed circuit board is arranged at the end of the case opposite the cap with the sound port.

In an exemplary embodiment, the case comprises a plurality of spacers or embossings facing inwards for locally supporting an outer surface of the hollow body formed from the printed circuit board. In this way, a part of the printed circuit board arranged between the spacers or embossings may then be spaced from the inner surface of the case. In particular, the hollow body may not touch the inner surface of the case with its entire outer surface but may be generally spaced from the inner surface of the case.

In an exemplary embodiment, a back volume is provided by a spacing between an outer surface of the hollow body and an inner surface of the case. A front volume may be delimited by an inner surface of the hollow body. The front volume may be acoustically connected to the sound port, e.g., a sound tube.

In an exemplary embodiment, a back volume may be delimited by an inner surface of the hollow body. A front volume may be provided by a spacing between an outer surface of the hollow body and an inner surface of the case. The front volume may be acoustically connected to the sound port, e.g., a sound tube.

In an exemplary embodiment, a spacing between an outer surface of the hollow body and an inner surface of the case is filled or covered with a substance, e.g., a sealing material. For instance, the substance may comprise a glue. For example, the substance may provide for a sealing of acoustic gaps.

According to an aspect of the present invention, a method of producing a receiver for a hearing instrument is proposed, the method comprising:
- providing a case having a tubular shape with at least one open end,
- providing a flexible or partially flexible printed circuit board and populating it with a plurality of MEMS receiver cells,
- folding the printed circuit board to form a hollow body and inserted it into the case with the MEMS receiver cells facing inward and/or outward,
- closing the at least one open end of the case with at least one cap, wherein one of the caps comprises a sound port for guiding sound produced by the MEMS receiver cells out of the receiver.

The present invention provides a solution with multiple MEMS motors in one housing thus allowing for increased output power. With the combination of MEMS Motors, frame and/or unibody and filters, an optimization of acoustics, reliability and size can be achieved. The proposed solution allows for providing a receiver for a hearing instrument without the need for rare-earth metals.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### Brief Description of the Drawings

The present invention will become more fully understood from the detailed description given hereinbelow and the accompanying drawings which are given by way of illustration only, and thus, are not limitative of the present invention, and wherein:
- Figure 1: different schematic views of a receiver for a hearing instrument configured to be inserted into a human ear canal, the receiver comprising a printed circuit board,
- Figure 2: two schematic views of the printed circuit board,
- Figure 3: schematic views of an embodiment of the printed circuit board,
- Figure 4: schematic views of another embodiment of the printed circuit board,
- Figure 5: schematic views of yet another embodiment of the printed circuit board,
- Figure 6: schematic views of yet another embodiment of the printed circuit board,
- Figure 7: schematic views of yet another embodiment of the printed circuit board, and
- Figure 8: schematic views of yet another embodiment of the printed circuit board.

Corresponding parts are marked with the same reference symbols in all figures.

### Detailed Description of Preferred Embodiments

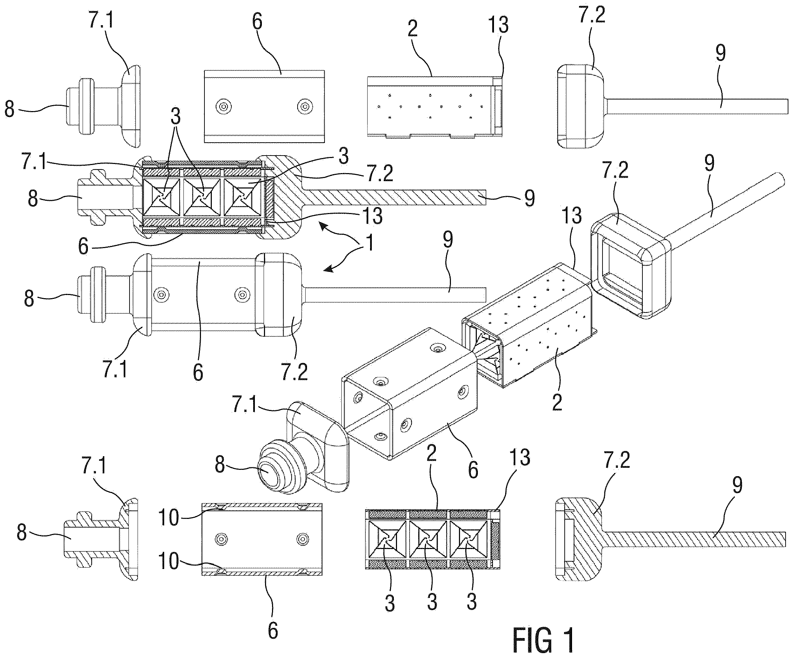

**Figure 1** shows different schematic views of a receiver 1 for a hearing instrument or a part thereof configured to be inserted into a human ear canal.

The receiver 1 comprises a flexible or partially flexible printed circuit board 2 populated on one side with a plurality of MEMS receiver cells 3. The printed circuit board 2 is folded to form a hollow body with the MEMS receiver cells 3 facing inward into an interior of the hollow body. A partially flexible printed circuit board 2 may be understood as a printed circuit board 2 comprising at least two generally rigid zones 4.1 to 4.n with a respective flexible fold 5.1 to 5.m serving as a hinge between pairs of adjacent rigid zones 4.1 to 4.n in each case, allowing the rigid zones 4.1 to 4.n to be folded relative to each other using the hinges.

The rigid zones 4.1 to 4.n may comprise a more rigid material than the flexible folds 5.1 to 5.m. Likewise, the rigid zones 4.1 to 4.n and the flexible folds 5.1 to 5.m may be made of the same material, the rigid zones 4.1 to 4.n being more rigid than the flexible folds 5.1 to 5.m due to the MEMS receiver cells 3 arranged thereon.

The hollow body formed this way from the printed circuit board 2 may have an at least basically tubular shape, e.g. with a polygonal, e.g. triangular, quadrangular, in particular rectangular or square, pentagonal, or hexagonal cross section, or with a circular or oval cross section. One of the ends of the hollow body formed this way may be closed by another one of the generally rigid zones 4.1 to 4.n of the printed circuit board 2, wherein this rigid zone 4.1 to 4.n may be populated with a control chip 12 for the MEMS receiver cells 3 facing inside or outside the hollow body or with another MEMS receiver cells 3. The control chip 12 may likewise be arranged instead of one of the MEMS receiver cells 3 on the other rigid zones 4.1 to 4.n.

The printed circuit board 2 forming the hollow body may be inserted into a case 6, which may also have a tubular shape, e.g. with a polygonal, e.g. triangular, quadrangular, in particular rectangular or square, pentagonal, or hexagonal cross section, or with a circular or oval cross section. Open ends of the tubular case 6 may be closed, in particular sealed, by a cap 7.1, 7.2 in each case, wherein one of the caps 7.1 may comprise a sound port 8 for guiding sound produced by the MEMS receiver cells 3 out of the receiver 1 into the ear canal. The sound port 8 may be configured to be connected to an ear tip for sealing against the ear canal walls. The other cap 7.2 may be arranged at the opposite end of the case 6 and have a cable 9 for electrically connecting the printed circuit board 2. If the hollow body formed from the printed circuit board 2 has a closed end as described above, this closed end may be positioned at the end of the case 6 covered by the latter cap 7.2.

The receiver 1 obtained this way has an elongate shape suitable for being fitted into a human ear canal.

The case 6 may comprise a plurality of spacers 10 or embossings 10 facing inwards for locally supporting an outer surface of the hollow body formed from the printed circuit board 2, so that the hollow body does not touch the inner surface of the case 6 with its entire outer surface but is generally spaced from the inner surface of the case 6.

In the illustrated example, a front volume of the speaker, as provided by MEMS receiver cells 3, may be defined as a volume delimited by an inner surface of the hollow body, e.g., a volume in front of the MEMS receiver cells 3. A back volume of the speaker may be defined as a volume enclosed between the outer surface of the hollow body and the inner surface of the case 6, e.g., as provided by the spacing of spacers 10.

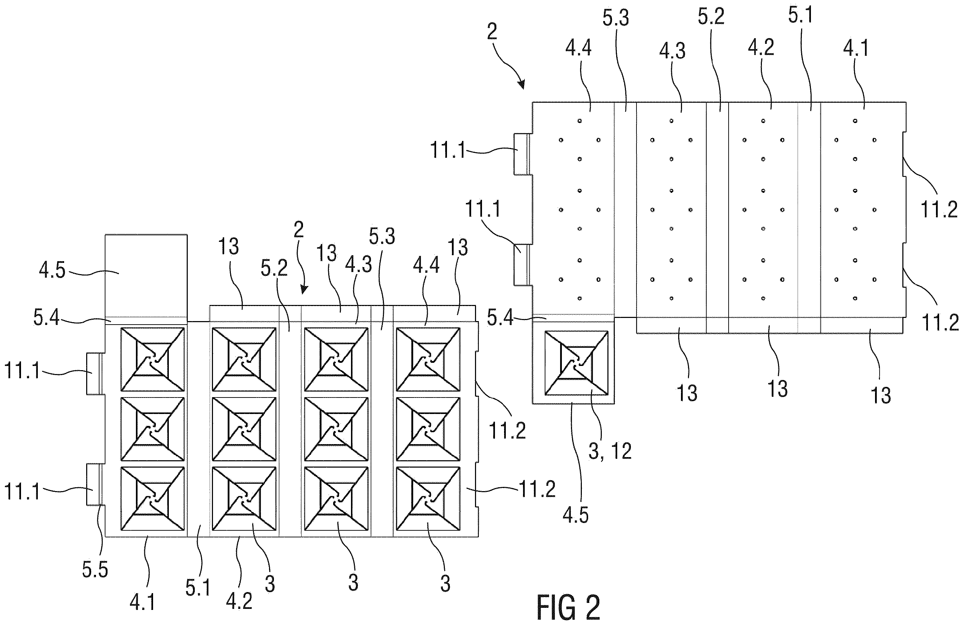

**Figure 2** shows two schematic views of the printed circuit board 2 used in figure 1. The printed circuit board 2 comprises four at least essentially rectangular rigid zones 4.1 to 4.4 populated with three MEMS receiver cells 3 each and arranged in parallel to each other with a respective fold 5.1 to 5.3 separating each pair of adjacent rigid zones 4.1 to 4.4. The folds 5.1 to 5.3 are thus also arranged in parallel. Prior to folding, the part of the printed circuit board 2 described so far is generally rectangular. The rigid zones 4.1 and 4.4 at opposite ends of the printed circuit board 2, e.g. at the shorter edges of the rectangle, may be provided with mutually complementary engagement structures 11.1, 11.2, configured to engage each other when the printed circuit board 2 is folded about the folds 5.1 to 5.3 to form the hollow body, so that the rigid zones 4.1 and 4.4 remain engaged to maintain the shape of the hollow body.

One of the rigid zones 4.1 to 4.4, e.g. the rigid zone 4.1, may have another fold 5.4 followed by another rigid zone 4.5 facing in another direction than the engagement structure 11.1, 11.2, e.g. toward one of the longer edges of the rectangle. This rigid zone 4.5 may be populated with one MEMS receiver cell 3. Once the hollow body is formed, the rigid zone 4.5 may be folded toward the hollow body about the fold 5.4 to close an end of the hollow body. At least one end of some or all parallel rigid zones 4.1 to 4.4 may have a lug 13 configured to engage in the respective cap 7.1, 7.2.

One of the engagement structures 11.1 may have another fold 5.5 allowing part of the engagement structure 11.1 to be folded toward the rigid zone 4.4 at the other end when the hollow body has been formed to maintain this shape.

The proposed solution provides a receiver 1 having a close-dense package of multiple MEMS-receiver cells 3 having a common speaker front volume.

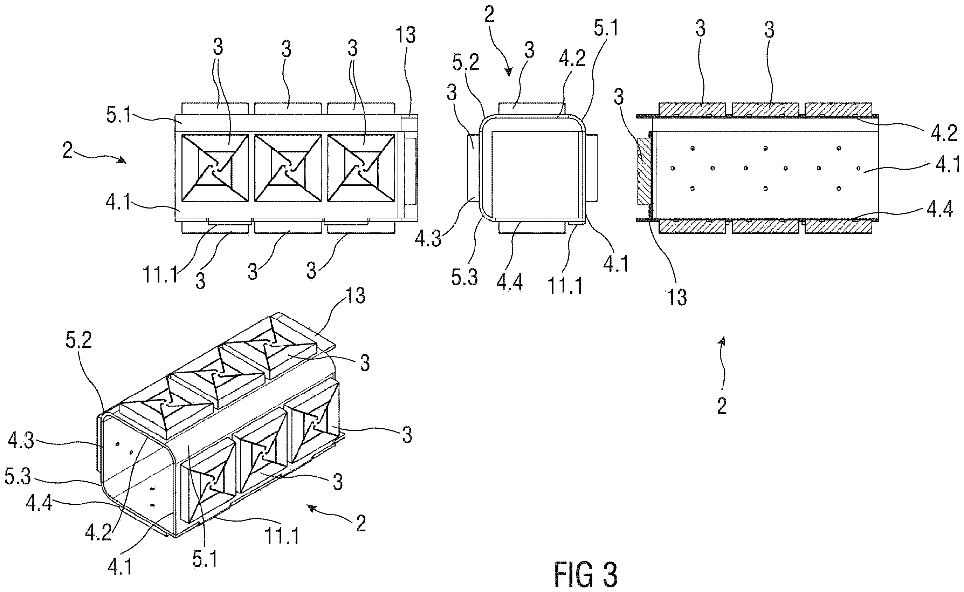

**Figure 3** shows schematic views of an embodiment of the printed circuit board 2 forming the hollow body. This embodiment is basically an inside out variant of the embodiment of figures 1 and 2. Instead of facing inward into the interior, the MEMS receiver cells 3 on the parallel rigid zones 4.1 to 4.4 face outward.

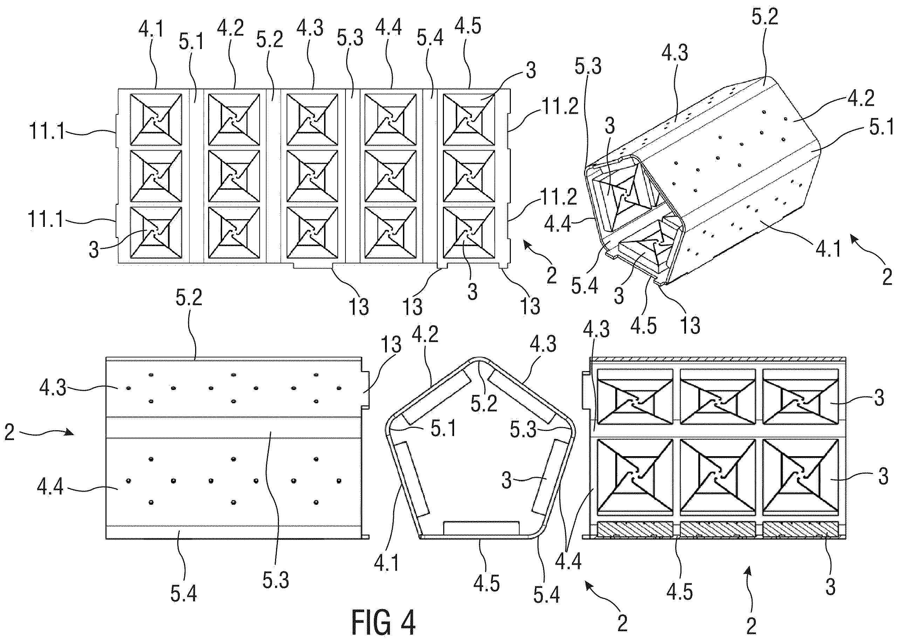

**Figure 4** shows schematic views of an embodiment of the printed circuit board 2 forming the hollow body. In this embodiment the printed circuit board 2 has five parallel, at least essentially rectangular, rigid zones 4.1 to 4.5 separated by folds 5.1 to 5.4, so that the printed circuit board 2 can be folded to form a hollow body having a pentagonal cross section. The MEMS receiver cells 3 on the parallel rigid zones 4.1 to 4.5 face inward, but could likewise face outward in another embodiment. In the embodiment of figure 4, both ends of the hollow body are open. However, in other embodiments, one of the ends may be closed by another rigid zone 4.6 as in figures 1 and 2.

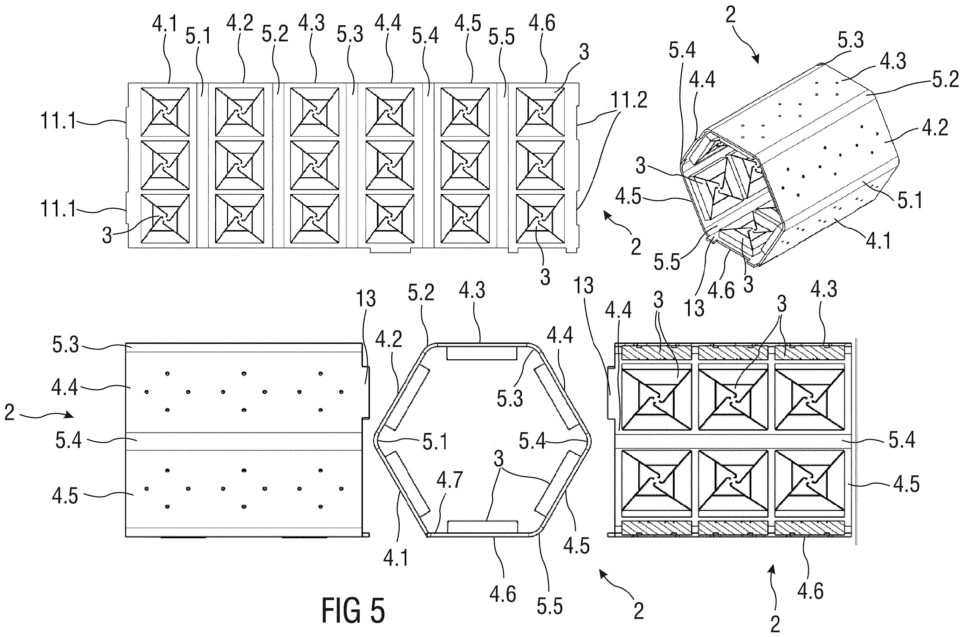

**Figure 5** shows schematic views of an embodiment of the printed circuit board 2 forming the hollow body. In this embodiment the printed circuit board 2 has six parallel, at least essentially rectangular, rigid zones 4.1 to 4.6 separated by folds 5.1 to 5.5, so that the printed circuit board 2 can be folded to form a hollow body having a hexagonal cross section. The MEMS receiver cells 3 on the parallel rigid zones 4.1 to 4.6 face inward, but could likewise face outward in another embodiment. In the embodiment of figure 5, both ends of the hollow body are open. However, in other embodiments, one of the ends may be closed by another rigid zone 4.7 as in figures 1 and 2.

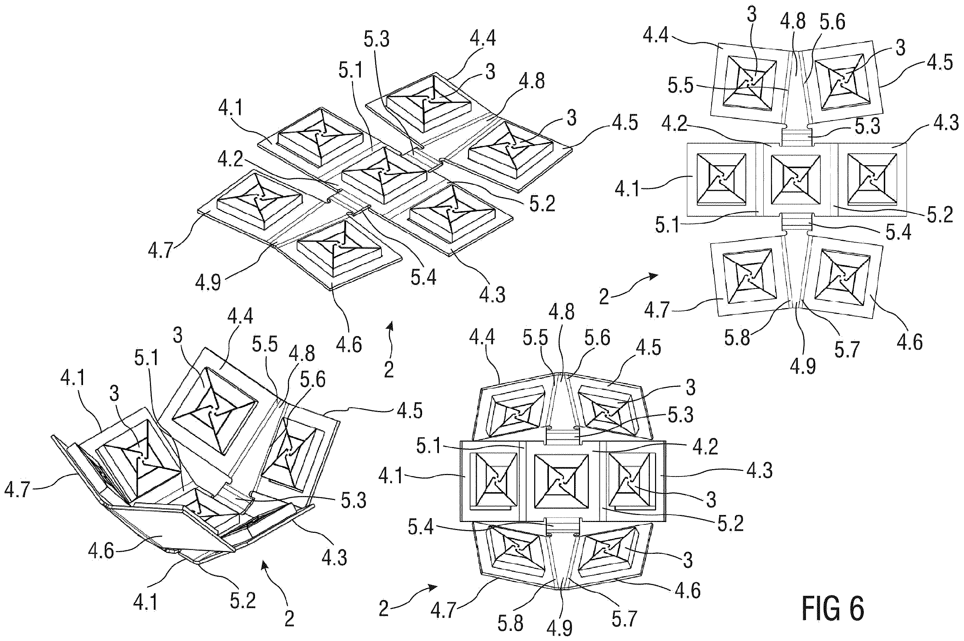

**Figure 6** shows schematic views of an embodiment of the printed circuit board 2 forming the hollow body. In this embodiment the printed circuit board 2 has seven rigid zones 4.1 to 4.7 populated with a MEMS receiver cell 3 each. Three of the rigid zones 4.1 to 4.3 are arranged in a row and separated by folds 5.1 and 5.2. The middle one of these rigid zones 4.2 further has an adjacent fold 5.3 at an edge 90° offset from the rigid zones 4.1, 4.3, and an adjacent fold 5.4 at an edge opposite of fold 5.3. Folds 5.3, 5.4 are each followed by another rigid zone 4.8, 4.9 basically shaped as a wedge or an isosceles triangle with two equal length edges and a base. The base is attached to the respective fold 5.3, 5.4. These two rigid zones 4.8, 4.9 may not be populated by MEMS receiver cells 3. The two equal length edges of the triangle have adjacent folds 5.5 to 5.8 followed by a respective rigid zone 4.4 to 4.7 which is again populated by a respective MEMS receiver cell 3.

The rigid zones 4.1 to 4.7 may be at least essentially square. While the folds 5.1, 5.2, 5.5 to 5.8 may have at least basically the same length as the edges of the rigid zones 4.1 to 4.7 they are connecting, the folds 5.3, 5.4 at the base of the triangular rigid zones 4.8, 4.9 may be shorter, e.g. half as long as the respectively adjacent edge of the middle rigid zone 4.2 or less, wherein said folds 5.3, 5.4 may be centered on this edge. The two folds 5.3, 5.4 may actually be two consecutive folds 5.3, 5.3' and 5.4, 5.4' in each case, spaced apart by a small rigid zone 4.10, 4.11 in each case to increase the distance between the middle rigid zone 4.2 and the wedge shaped or triangular rigid zones 4.8, 4.9. There may be a respective indentation 14 in the edge of the middle rigid zone 4.2 on each side of the fold 5.3, 5.4 and/or in the equal length edges of the wedge shaped or triangular rigid zones 4.8, 4.9 adjacent the folds 5.3, 5.4 or 5.3', 5.4'.

The printed circuit board 2 of figure 6 may be folded to form a more open hollow body having a concave shape. The concave shape may resemble a water lily, a bowl or a concave mirror. This may be particularly useful for being applied in a receiver 1 for an earbud.

The MEMS receiver cells 3 may face inward, e.g., relative to the concavely shaped surface, but could likewise face outward in another embodiment.

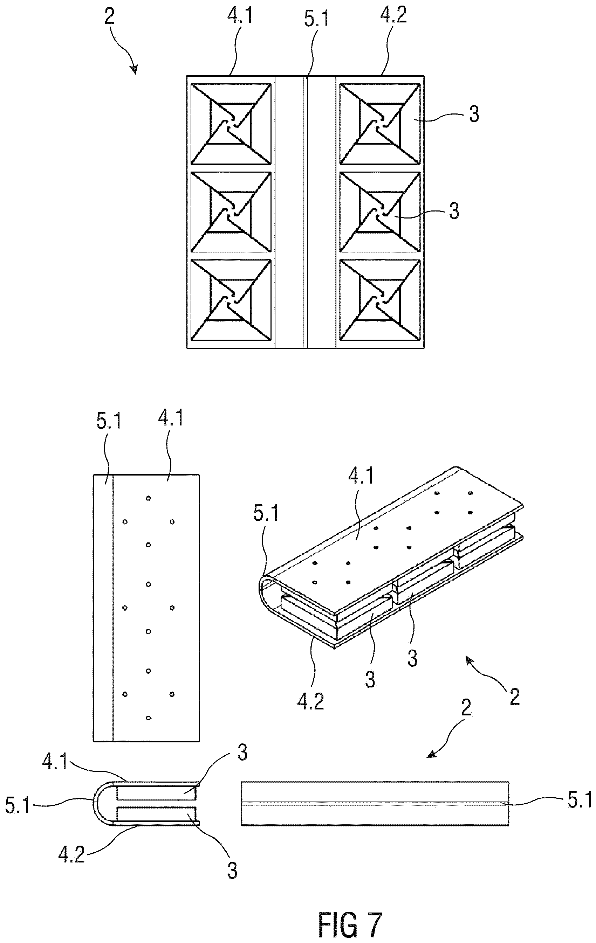

**Figure 7** shows schematic views of an embodiment of the printed circuit board 2 forming the hollow body. In this embodiment the printed circuit board 2 has two parallel rigid zones 4.1 to 4.2 separated by a fold 5.1, so that one of the rigid zones 4.1 can be folded onto the other rigid zone 4.2 to resemble a booklet. The two rigid zones 4.1, 4.2 may be rectangular and are each populated with multiple MEMS receiver cells 3 in a row, e.g. three MEMS receiver cells 3 each.

The MEMS receiver cells 3 on the parallel rigid zones 4.1, 4.2 face inward, but could likewise face outward in another embodiment. While the folds in the previous embodiments may typically be rather slim compared to the rigid zones 4.1 to 4.n they connect, the fold 5.1 in the embodiment of figure 7 may be wider, e.g. almost as wide as the MEMS receiver cells 3 on the adjacent rigid zones 4.1, 4.2 to allow for a greater bending radius of the fold 5.1 when the rigid zones 4.1, 4.2 are folded upon each other to maintain a distance between the MEMS receiver cells 3 arranged opposite each other in this state.

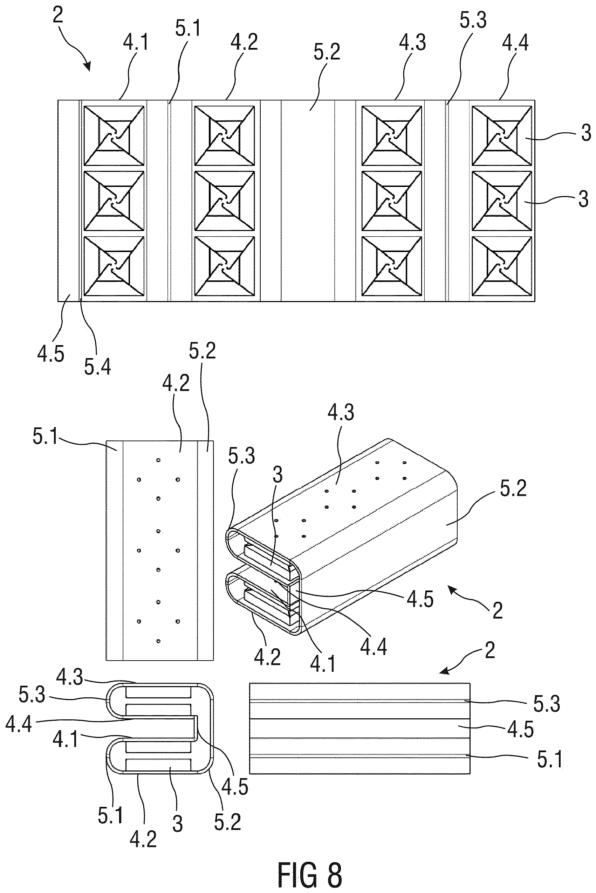

**Figure 8** shows schematic views of an embodiment of the printed circuit board 2 forming the hollow body. In this embodiment the printed circuit board 2 has four parallel rigid zones 4.1 to 4.4, each pair of adjacent rigid zones 4.1 to 4.4 separated by a respective fold 5.1 to 5.3, so that the outer rigid zones 4.1, 4.4 can be folded onto the respectively adjacent inner rigid zone 4.2, 4.3 to form pairs resembling a booklet in each case, and these pairs can again be folded about the middle fold 5.2 one upon the other so that the final shape resembles a book wrapper. The four rigid zones 4.1, 4.4 may be rectangular and are each populated with multiple MEMS receiver cells 3 in a row, e.g. three MEMS receiver cells 3 each.

The MEMS receiver cells 3 on the parallel rigid zones 4.1 to 4.4 face inward for each pair, but could likewise face outward in another embodiment. While the folds in the previous embodiments may typically be rather slim compared to the rigid zones 4.1 to 4.n they connect, the folds 5.1 to 5.3 in the embodiment of figure 8 may be wider, e.g. almost as wide as the MEMS receiver cells 3 on the adjacent rigid zones 4.1 to 4.4 within the pairs to allow for a greater bending radius of the fold 5.1 when the rigid zones 4.1 to 4.4 are folded upon each other to maintain a distance between the MEMS receiver cells 3 arranged opposite each other in this state in each pair. The middle fold 5.2 may be even wider, e.g. wider than the adjacent rigid zones 4.2, 4.3 to allow for an even greater bending radius of the fold 5.2 when the two pairs are folded upon each other to maintain a distance between the pairs in this state. A small additional rigid zone 4.5 may be coupled by another fold 5.4 to one of the outer rigid zones 4.1, 4.4. This additional rigid zone 4.5 may not be populated by MEMS receiver cells 3 and have a width about half the width of the folds 5.1, 5.3 between the rigid zones 4.1, 4.2 and 4.3, 4.4 within each pair. The additional rigid zone 4.5 may be folded in the opposite direction about the fold 5.4 compared to all other folds 5.1 to 5.3 to function as a spacer 10 between the pairs.

Populating the MEMS receiver cells 3 or MEMS motors on a printed circuit board 2 with flexible bending zones allows optimizing the shape for insertion into the ear-canal, not just for hearing devices that are placed in the concha.

MEMS receiver cells 3 or MEMS motors can be brittle; therefore, it is proposed to populate them on a rigid printed circuit board 2.

The described concept could also be designed as a modular design. Using a base cell and various printed circuit boards 2 or zones with different number and orientation may allow different power levels.

The folded printed circuit board 2 needs to be fixed in a support structure, e.g. a frame, which is inserted into a case 6 or a case 6 with appropriate supports such as the embossings 10. The case 6 may for example be made of sheet metal.

Any wires of the receiver 1 may be soldered or bonded to contact pads arranged on the printed circuit board 2.

The receiver 1 could be built in a modular way, e.g. as a stacking of flexible printed circuit boards 2 may add flexibility of power and size.

The case 6 may be a sheet metal sleeve with embossments 10 to ensure proper thickness and/or distance of a back-volume (i.e. the volume between the printed circuit board 2 and the wall of the case 6.

The caps 7.1, 7.2 may be made from plastics and have slots for receiving the lugs 13 of the printed circuit board 2 for proper positioning.

During mounting of the caps 7.1, 7.2, a front- and back volume may be separated (sealing) by gluing the lugs 13 of the printed circuit board 2 into slots within the caps 7.1, 7.2 using an adhesive or potting sealing.

The control chip 12 may be placed regularly on the printed circuit board 2 by omitting one MEMS receiver cell 3 and replacing it with the control chip 12 in any of the above described embodiments.

The printed circuit board 2 may also be populated by any other chips or ASICS (e.g. none volatile memory - NVM, sensor electronics).

By combining multiple MEMS receiver cells 3 in one case 6, the acoustic output may be increased.

### List of References

- 1: receiver
- 2: printed circuit board
- 3: MEMS receiver cell
- 4.1 to 4.n: rigid zone
- 5.1 to 5.m, 5.3', 5.4': fold
- 6: case
- 7.1,7.2: cap
- 8: sound port
- 9: cable
- 10: spacer, embossing
- 11.1, 11.2: engagement structure
- 12: control chip
- 13: lug
- 14: indentation

## Claims

1. A receiver (1) for a hearing instrument, the receiver (1) comprising:
- a case (6) having a tubular shape with at least one open end,
- a flexible or partially flexible printed circuit board (2) populated with a plurality of MEMS receiver cells (3), wherein the printed circuit board (2) is folded to form a hollow body and inserted in the case (6) with the MEMS receiver cells (3) facing inward and/or outward,
- at least one cap (7.1, 7.2) closing the open end of the case (6), wherein one of the caps (7.1) comprises a sound port (8) for guiding sound produced by the MEMS receiver cells (3) out of the receiver (1).

2. The receiver (1) of claim 1, wherein the partially flexible printed circuit board (2) comprises at least two generally rigid zones (4.1 to 4.n) with a respective flexible fold (5.1 to 5.m) serving as a hinge between pairs of adjacent rigid zones (4.1 to 4.n) in each case, wherein at least some of the rigid zones (4.1 to 4.n) are populated with the plurality of MEMS receiver cells (3), wherein the rigid zones (4.1 to 4.n) comprise a more rigid material than the flexible folds (5.1 to 5.m) or are made of the same material but are more rigid than the flexible folds (5.1 to 5.m) due to the MEMS receiver cells (3) arranged thereon.

3. The receiver (1) of claim 1 or 2, wherein the hollow body formed from the printed circuit board (2) has an at least basically tubular shape.

4. The receiver (1) according to any one of the preceding claims, wherein the case (6) and/or the hollow body formed from the printed circuit board (2) have/has a polygonal, e.g. triangular, quadrangular, in particular rectangular or square, pentagonal, or hexagonal cross section, or a circular or oval cross section.

5. The receiver (1) according to any one of the preceding claims, wherein the printed circuit board (2) comprises two, three, four, five, six or more at least essentially rectangular rigid zones (4.1 to 4.4) populated with one or more MEMS receiver cells (3) each and arranged in parallel to each other with a respective fold (5.1 to 5.3) separating each pair of adjacent rigid zones (4.1 to 4.4).

6. The receiver (1) according to any one of the preceding claims, wherein one of the ends of the hollow body formed from the printed circuit board (2) is closed by another rigid zone (4.1 to 4.n) of the printed circuit board (2).

7. The receiver (1) according to any one of the preceding claims, wherein two rigid zones (4.1 to 4.n) at opposite ends of the printed circuit board (2) comprise mutually complementary engagement structures (11.1, 11.2) configured to engage each other when the printed circuit board (2) is folded to form the hollow body.

8. The receiver (1) according to any one of the preceding claims, wherein at least one end of some or all parallel rigid zones (4.1 to 4.4) have a lug (13) configured to engage in a slot in the cap (7.1, 7.2).

9. The receiver (1) according to any one of the preceding claims, wherein the printed circuit board (2) has two parallel rigid zones (4.1, 4.2) separated by a fold (5.1), wherein one of the rigid zones (4.1) is folded onto the other rigid zone (4.2).

10. The receiver (1) according to any one of the preceding claims, wherein the printed circuit board (2) has four parallel rigid zones (4.1 to 4.4) including two outer ones and two inner ones, wherein adjacent rigid zones (4.1 to 4.4) are separated by a respective fold (5.1 to 5.3), wherein each outer rigid zone (4.1, 4.4) is folded onto the respectively adjacent inner rigid zone (4.2, 4.3) to form a pair, wherein the pairs are folded about a middle one of the folds (5.2) one upon the other.

11. The receiver (1) according to claim 1 or 2, wherein the printed circuit board (2) is folded to form a hollow body having a concave shape.

12. The receiver (1) according to any one of the preceding claims, wherein at least one control chip (12) configured to control the MEMS receiver cells (3) is arranged on at least one of the rigid zones (4.1 to 4.n).

13. The receiver (1) according to any one of the preceding claims, wherein a cap (7.2) having a cable (9) for electrically connecting the printed circuit board (2) is arranged at the end of the case (6) opposite the cap (7.1) with the sound port (8).

14. The receiver (1) according to any one of the preceding claims, wherein the case (6) comprises a plurality of spacers (10) or embossings (10) facing inwards for locally supporting an outer surface of the hollow body formed from the printed circuit board (2).

15. A method of producing a receiver (1) for a hearing instrument, comprising:
- providing a case (6) having a tubular shape with at least one open end,
- providing a flexible or partially flexible printed circuit board (2) and populating it with a plurality of MEMS receiver cells (3),
- folding the printed circuit board (2) to form a hollow body and inserted it into the case (6) with the MEMS receiver cells (3) facing inward and/or outward,
- closing the at least one open end of the case (6) with at least one cap (7.1, 7.2), wherein one of the caps (7.1) comprises a sound port (8) for guiding sound produced by the MEMS receiver cells (3) out of the receiver (1).
